# EUROPÄISCHE PATENTSCHRIFT

(11) **EP 1 951 928 B1**
(45) Veröffentlichungstag und Bekanntmachung des Hinweises auf die Patenterteilung: **29.03.2017**
(21) Anmeldenummer: 06807343.6
(22) Anmeldetag: 17.10.2006
(51) Int. Cl.: C23C 14/08

(54) **SCHICHTSYSTEM MIT GADOLINIUM-MISCHKRISTALL-PYROCHLORPHASE**
COATING SYSTEM INCLUDING A MIXED GADOLINIUM PYROCHLOR PHASE.
SYSTÈME DE REVÊTEMENT CONTENANT UN PHASE PYROCHLOR MIXTE DE GADOLINIUM.

(30) Priorität: 24.11.2005 EP 05025690
(43) Veröffentlichungstag der Anmeldung: 06.08.2008
(60) Teilanmeldung: 10014407.0
(73) Patentinhaber: Siemens Aktiengesellschaft, 80333 München (DE)
(72) Erfinder: SCHUMANN, Eckart, 45468 Mülheim an der Ruhr (DE); SUBRAMANIAN, Ramesh, 32765 Oviedo, FL (US); KAISER, Axel, 41462 Neuss (DE)
(86) Internationale Anmeldenummer: PCT/EP2006/067497
(87) Internationale Veröffentlichungsnummer: WO 2007/060062

(56) Entgegenhaltungen:
- EP-A- 0 713 957
- EP-A- 0 992 603
- EP-A1- 0 897 996
- US-A1- 2004 038 085
- US-A1- 2004 180 233
- US-A1- 2005 238 907
- US-B1- 6 258 467
- PATENT ABSTRACTS OF JAPAN Bd. 017, Nr. 334 (E-1387), 24. Juni 1993 (1993-06-24) -& JP 05 041237 A (NIPPON TELEGR & TELEPH CORP <NTT>), 19. Februar 1993 (1993-02-19)

## Beschreibung

Die Erfindung betrifft ein Schichtsystem mit Pyrochloren.

Ein solches Schichtsystem weist ein Substrat mit einer Metalllegierung auf der Basis von Nickel oder Kobalt auf. Derartige Erzeugnisse dienen vor allem als Bauteil einer Gasturbine, insbesondere als Gasturbinenschaufeln oder Hitzeschilde. Die Bauteile sind einem Heißgasstrom von aggressiven Verbrennungsgasen ausgesetzt. Daher müssen sie hohen thermischen Belastungen Stand halten können. Des Weiteren ist es erforderlich, dass diese Bauteile oxidations- und korrosionsbeständig sind. Vor allem an bewegliche Bauteile, z. B. Gasturbinenschaufeln, aber auch an statische Bauteile sind fernerhin mechanische Anforderungen zu stellen. Die Leistung und der Wirkungsgrad einer Gasturbine, in der heißgasbelastbare Bauteile Verwendung finden, steigen mit zunehmender Betriebstemperatur. Um einen hohen Wirkungsgrad und eine hohe Leistung zu erzielen, werden durch die hohen Temperaturen besonders belastete Komponenten der Gasturbinen mit einem keramischen Werkstoff beschichtet. Dieser wirkt als Wärmedämmschicht zwischen dem Heißgasstrom und dem metallischen Substrat.

Vor dem aggressiven Heißgasstrom wird der metallische Grundkörper durch Beschichtungen geschützt. Dabei weisen moderne Bauteile zumeist mehrere Beschichtungen auf, die jeweils spezifische Aufgaben erfüllen. Es liegt somit ein Mehrschichtsystem vor.

Da Leistung und Wirkungsgrad von Gasturbinen mit zunehmender Betriebstemperatur steigen, wurde immer wieder versucht, durch Verbesserung des Beschichtungssystems eine höhere Leistungsfähigkeit von Gasturbinen zu erzielen.

Die EP 0 944 746 B1 offenbart die Verwendung von Pyrochloren als Wärmedämmschicht. Jedoch sind für den Einsatz eines Materials als Wärmedämmschicht nicht nur gute wärmedämmende Eigenschaften notwendig, sondern auch eine gute Anbindung an das Substrat.

Die EP 0 992 603 A1 offenbart eine Wärmedämmschichtsystem aus Gadoliniumoxid und Zirkonoxid, das keine Pyrochlorstruktur aufweisen soll.

Die JP05041237 offenbart ein Schichtsystem für Feststoffbrenzellen, das auf einer Elektrode eine Pyrochlorschicht aufweist, die mit weiteren Schichten überdeckt ist.

Die US6258467 offenbart Schichtsysteme für Gasturbinen, die eine Pyrochlorschicht enthalten, die eine wärmedämmende Funktion hat.

Es ist daher Aufgabe der Erfindung ein Schichtsystem aufzuzeigen, das gute wärmedämmende Eigenschaften sowie eine gute Anbindung an das Substrat und damit eine lange Lebensdauer aufweist.

Die Aufgabe wird gelöst durch ein Schichtsystem gemäß Anspruch 1.

Der Erfindung liegt die Erkenntnis zugrunde, dass das gesamte System als Einheit betrachtet werden muss und nicht einzelne Schichten oder einzelne Schichten untereinander isoliert von einander betrachtet und optimiert werden dürfen, um eine lange Lebensdauer zu erzielen.

In den Unteransprüchen sind weitere vorteilhafte Maßnahmen aufgeführt, die beliebig in vorteilhafter Art und Weise kombiniert werden können.

Das erfindungsgemäße Schichtsystem besteht aus einer äußeren keramischen Schicht, die einen Mischkristall aus Gadoliniumzirkonat und Gadoliniumhafnat aufweist, der besonders gute thermische Eigenschaften (an das Substrat angepasster Ausdehnungskoeffizient, geringer Wärmeleitkoeffizient) aufweist und sehr gut harmoniert mit einer Zwischenschicht und dem Substrat des Bauteils.

Ausführungsbeispiele der Erfindung werden nachfolgend unter Bezugnahme auf die Zeichnungen noch näher erläutert.

Es zeigen
- Figur 1: ein erfindungsgemäßes Schichtsystem,
- Figur 2: Zusammensetzungen von Superlegierungen,
- Figur 3: eine Gasturbine,
- Figur 4: eine perspektivische Ansicht einer Turbinenschaufel,
- Figur 5: eine perspektivische Ansicht einer Brennkammer.

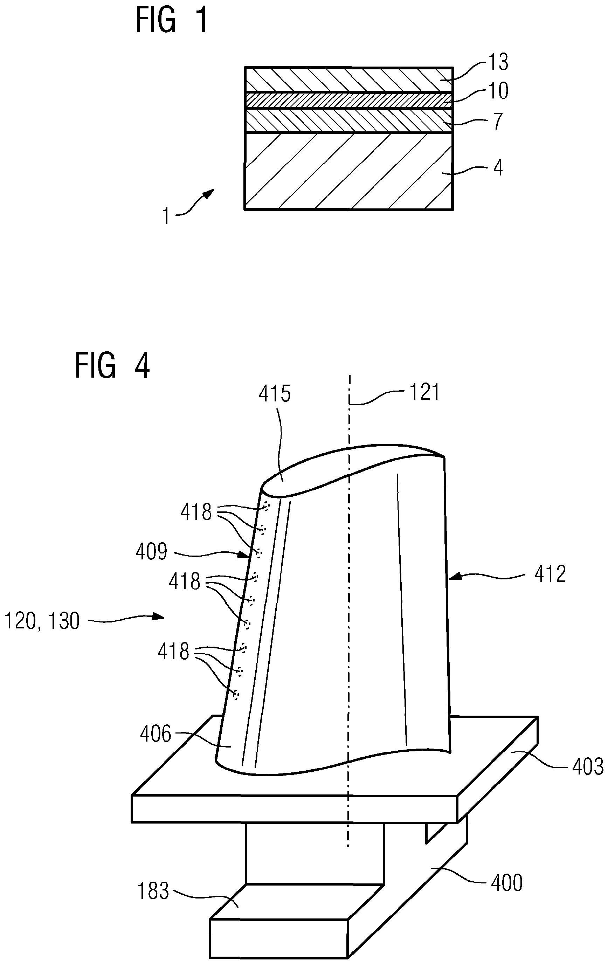

Figur 1 zeigt ein erfindungsgemäßes Schichtsystem 1.

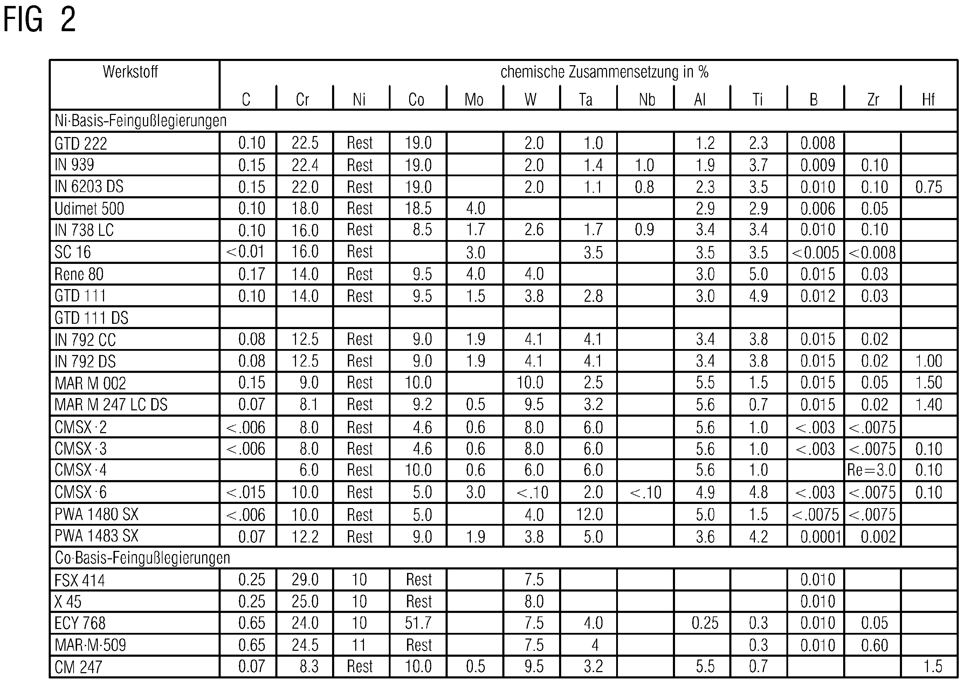

Das Schichtsystem 1 besteht aus einem metallischen Substrat 4, das insbesondere für Bauteile bei hohen Temperaturen aus einer nickel- oder kobaltbasierten Superlegierung (Fig. 2) besteht.

Direkt auf dem Substrat 4 ist vorzugsweise eine metallische Anbindungsschicht 7 des Typs MCrAlX, insbesondere des Typs NiCoCrALX vorhanden, die vorzugsweise entweder

| | |
|---|---|
| (11 - 13)wt% | Kobalt, insbesondere 12wt% Kobalt, |
| (20 - 22)wt% | Chrom, insbesondere 21wt% Chrom, |
| (10,5 - 11,5)wt% | Aluminium, insbesondere 11wt% Aluminium, |
| (0,3 - 0,5)wt% | Yttrium (=X), insbesondere 0,4wt% Yttrium, |
| (1,5 - 2,5)wt% | Rhenium und insbesondere 2,0wt% Rhenium |

Rest Nickel
oder vorzugsweise aus

| | |
|---|---|
| (24 - 26)wt% | Kobalt, insbesondere 25wt% Kobalt, |
| (16 - 18)wt% | Chrom, insbesondere 17wt% Chrom, |
| (9,5 - 10,5)wt% | Aluminium, insbesondere 10wt% Aluminium, |
| (0,3 - 0,5)wt% | Yttrium (=X), insbesondere 0,4wt% Yttrium, |
| (1 - 2,0)wt% | Rhenium und insbesondere 1,5wt% Rhenium, |

Rest Nickel aufweist,
oder vorzugsweise aus

| | |
|---|---|
| 29% - 31% | Nickel, insbesondere 30% Nickel, |
| 27% - 29% | Chrom, insbesondere 28% Chrom, |
| 7% - 9% | Aluminium, insbesondere 8% Aluminium, |
| 0,5% - 0,7% | Yttrium, insbesondere 0,6% Yttrium, |
| 0,6% - 0,8% | Silizium, insbesondere 0,7% Silizium und |

Rest Kobalt aufweist
oder vorzugsweise aus

| | |
|---|---|
| 27% - 29% | Nickel, insbesondere 28% Nickel, |
| 23% - 25% | Chrom, insbesondere 24% Chrom, |
| 9% - 11% | Aluminium, insbesondere 10% Aluminium, |
| 0,3% - 0,7% | Yttrium, insbesondere 0,6% Yttrium und, |

Rest Kobalt aufweist.

Insbesondere besteht die NiCoCrAlY Anbindungsschicht 7 aus einer dieser Zusammensetzungen.

Auf dieser metallischen Anbindungsschicht 7 ist bereits vor dem Aufbringen weiterer keramischer Schichten eine Aluminiumoxidschicht entstanden während des Betriebs entsteht eine solche Aluminiumoxidschicht (TGO).
Auf der metallischen Anbindungsschicht 7 oder auf der Aluminiumoxidschicht (nicht dargestellt) ist vorzugsweise eine innere keramische Schicht 10, vorzugsweise eine vollständig oder teilweise stabilisierte Zirkonoxidschicht vorhanden. Vorzugsweise wird Yttrium-stabilisiertes Zirkonoxid, vorzugsweise mit 6wt% - 8wt% Yttrium verwendet. Ebenso kann Kalziumoxid, Ceroxid oder Hafniumoxid zur Stabilisierung von Zirkonoxid verwendet werden.
Das Zirkonoxid wird vorzugsweise als plasmagespritzte Schicht aufgetragen, kann vorzugsweise auch als kolumnare Struktur mittels Elektronenstrahlverdampfen (EBPVD) aufgebracht werden.

Auf der TGO, auf der Anbindungsschicht 7 oder auf der inneren Schicht 10 ist eine äußere keramische Schicht 13 aufgebracht, die erfindungsgemäß einen Mischkristall aus Gadolinium, Hafnium und Zirkon mit Pyrochlorstruktur umfasst.
Eine Pyrochlorstruktur weist die Summenformel A₂B₂O₇ auf oder allgemein A_{V}B_{X}O_{Z} wobei v = 2, x = 2 und z = 7 ist. Abweichungen von dieser stöchiometrischen Zusammensetzung für v, x und z können durch Fehlstellen oder geringe, bewusste oder unbewusste Dotierungen entstehen.

Für die erfindungsgemäße äußere keramische Schicht 13 wird Gadolinium (Gd) für A, Hafnium und Zirkon (Hf, Zr) für B verwendet, also eine Mischkristallstruktur Gdᵥ(Hf_{X}Zr_{Y})O_{Z}. Auch hier können geringe Abweichungen von dieser Stöchiometrie auftreten.
Die äußere keramische Schicht 13 umfasst Gdᵥ(HfₓZr_{y})O_{z} mit x + y = 2.
Vorzugsweise umfasst die äußere keramische Schicht 13 auch Gdᵥ(HfₓZr_{y})O₇.
Vorzugsweise umfasst die äußere keramische Schicht 13 Gd₂(HfₓZr_{y})O₂.
Vorzugsweise besteht die äußere keramische Schicht 13 aus Gdᵥ(HfₓZr_{y})O_{z}, insbesondere mit v = 2, x+y = 2 und z = 7. Dabei können beliebige Mischungsverhältnisse y:x von Zirkon und Hafnium verwendet werden.
Vorzugsweise wird ein größerer Anteil von Zirkon verwendet. Ebenso werden vorzugsweise Mischungsverhältnisse von 10:90, 20:80, 30:70 oder 40:60 für Hafnium zu Zirkon verwendet. Weiterhin vorteilhaft ist es, Mischungsverhältnisse von 50:50, 60:40, 70:30, 80:20 oder 90:10 für Hafnium zu Zirkon zu verwenden.
Für die Verhältnisse von x zu y gelten also vorteilhafter Weise genannte Angaben für das Verhältnis von Hafnium zu Zirkon (Hf : Zr = 80:20 entspricht y:x= 1.6 : 0.4).
Die Schicht kann aus einem Pulver hergestellt worden sein, das die Anteile der oben genannten Zusammensetzung ergibt. Ebenso können sich die Mischkristalle auch beim Beschichtungsprozess oder durch eine Wärmebehandlung nach dem Beschichtungsprozess erzeugt werden.
Die Schichtdicke der inneren Schicht 10 beträgt vorzugsweise zwischen 10% und 50% der Gesamtschichtdicke D von innerer Schicht 10 und äußerer Schicht 13.
Vorzugsweise liegt die Schichtdicke der inneren Schicht 10 zwischen 10% und 40% oder zwischen 10% und 30% der Gesamtschichtdicke.

Ebenso vorteilhaft ist es, wenn die Schichtdicke der inneren Schicht 10 10% bis 20% der Gesamtschichtdicke aufweist. Ebenso vorzugsweise ist es, wenn die Schichtdicke der inneren Schicht 10 zwischen 20% und 50% oder zwischen 20% und 40% der Gesamtschichtdicke beträgt.
Wenn der Anteil der inneren Schicht 10 an der Gesamtschichtdicke zwischen 20% und 30% liegt, werden ebenso vorteilhafte Ergebnisse erzielt.
Vorzugsweise beträgt die Schichtdicke der inneren Schicht 10 30% bis 50% der Gesamtschichtdicke.

Ebenso vorteilhaft ist es, wenn die Schichtdicke der inneren Schicht 10 30% bis 40% der Gesamtschichtdicke aufweist. Ebenso vorzugsweise ist es, wenn die Schichtdicke der inneren Schicht 10 zwischen 40% und 50% der Gesamtschichtdicke beträgt.
Obwohl die Pyrochlorphase bessere Wärmedämmungseigenschaften aufweist als die ZrO₂-Schicht, kann die ZrO₂-Schicht genauso dick ausgeführt werden wie die Pyrochlorphase.

Die innere keramische Schicht 10 hat vorzugsweise eine Dicke von 40µm bis 60µm, insbesondere 50µm ± 10 %.
Die Gesamtschichtdicke von der inneren Schicht 10 und der äußeren Schicht 13 beträgt vorzugsweise 300µm oder vorzugsweise 400 µm. Die maximale Gesamtschichtdicke beträgt vorteilhafterweise 800µm oder vorzugsweise maximal 600µm.

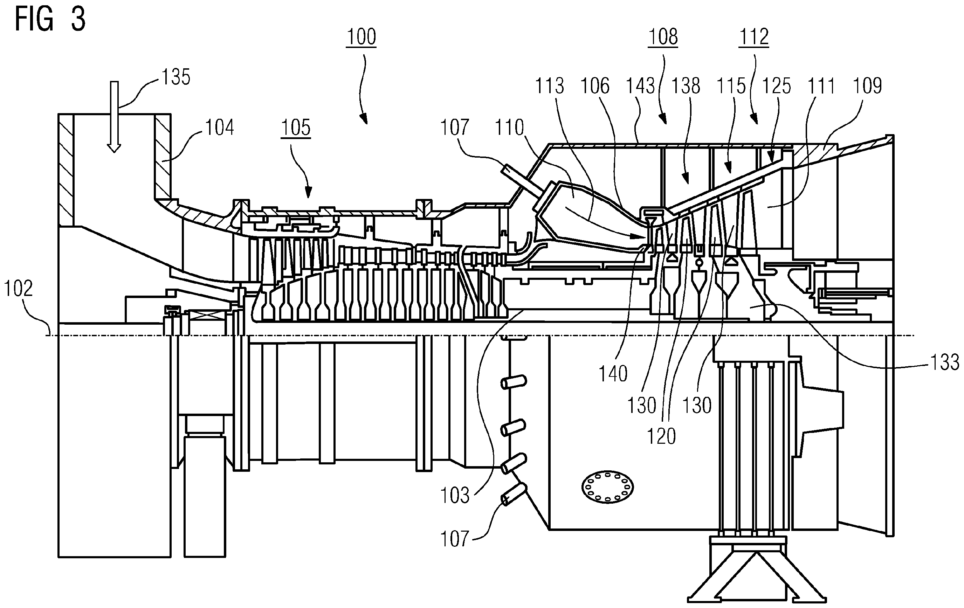

Die Figur 3 zeigt beispielhaft eine Gasturbine 100 in einem Längsteilschnitt.
Die Gasturbine 100 weist im Inneren einen um eine Rotationsachse 102 drehgelagerten Rotor 103 mit einer Welle 101 auf, der auch als Turbinenläufer bezeichnet wird.
Entlang des Rotors 103 folgen aufeinander ein Ansauggehäuse 104, ein Verdichter 105, eine beispielsweise torusartige Brennkammer 110, insbesondere Ringbrennkammer, mit mehreren koaxial angeordneten Brennern 107, eine Turbine 108 und das Abgasgehäuse 109.

Die Ringbrennkammer 110 kommuniziert mit einem beispielsweise ringförmigen Heißgaskanal 111. Dort bilden beispielsweise vier hintereinander geschaltete Turbinenstufen 112 die Turbine 108.
Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.
An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 110 auskleidenden Hitzeschildelementen am meisten thermisch belastet.
Um den dort herrschenden Temperaturen standzuhalten, können diese mittels eines Kühlmittels gekühlt werden.

Ebenso können Substrate der Bauteile eine gerichtete Struktur aufweisen, d.h. sie sind einkristallin (SX-Struktur) oder weisen nur längsgerichtete Körner auf (DS-Struktur).

Als Material für die Bauteile, insbesondere für die Turbinenschaufel 120, 130 und Bauteile der Brennkammer 110 werden beispielsweise eisen-, nickel- oder kobaltbasierte Superlegierungen verwendet.

Solche Superlegierungen sind beispielsweise aus der EP 1 204 776 B1, EP 1 306 454, EP 1 319 729 A1, WO 99/67435 oder WO 00/44949 bekannt; diese Schriften sind bzgl. der chemischen Zusammensetzung der Legierungen Teil der Offenbarung.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

Die Figur 4 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 und eine Schaufelspitze 415 auf.
Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).
Der Schaufelfuß 183 ist beispielsweise als Hammerkopf ausgestaltet. Andere Ausgestaltungen als Tannenbaum- oder Schwalbenschwanzfuß sind möglich.
Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.
Solche Superlegierungen sind beispielsweise aus der EP 1 204 776 B1, EP 1 306 454, EP 1 319 729 A1, WO 99/67435 oder WO 00/44949 bekannt; diese Schriften sind bzgl. der chemischen Zusammensetzung der Legierung Teil der Offenbarung.
Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind.

Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.
Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.

Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures).
Solche Verfahren sind aus der US-PS 6,024,792 und der EP 0 892 090 A1 bekannt; diese Schriften sind bzgl. des Erstarrungsverfahrens Teil der Offenbarung.

Ebenso können die Schaufeln 120, 130 Beschichtungen gegen Korrosion oder Oxidation aufweisen, z. B. (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1, die bzgl. der chemischen Zusammensetzung der Legierung Teil dieser Offenbarung sein sollen.
Die Dichte liegt vorzugsweise bei 95% der theoretischen Dichte.
Auf der MCrAlX-Schicht (als Zwischenschicht oder als äußerste Schicht) bildet sich eine schützende Aluminiumoxidschicht (TGO = thermal grown oxide layer).

Auf der MCrAlX kann noch eine Wärmedämmschicht vorhanden sein, die vorzugsweise die äußerste Schicht ist, und besteht aus dem erfindungsgemäßen Schichtsystem 1.

Die Wärmedämmschicht bedeckt die gesamte MCrAlX-Schicht. Durch geeignete Beschichtungsverfahren wie z.B. Elektronenstrahlverdampfen (EB-PVD) werden stängelförmige Körner in der Wärmedämmschicht erzeugt.

Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen. Die Wärmedämmschicht ist also vorzugsweise poröser als die MCrAlX-Schicht.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

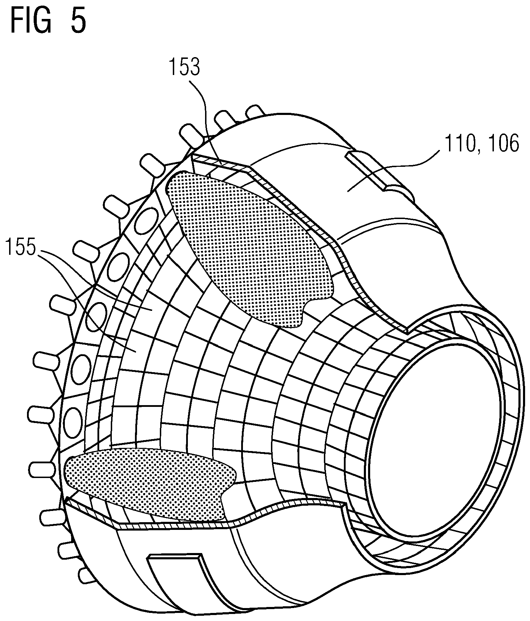

Die Figur 5 zeigt eine Brennkammer 110 der Gasturbine 100. Die Brennkammer 110 ist beispielsweise als so genannte Ringbrennkammer ausgestaltet, bei der eine Vielzahl von in Umfangsrichtung um eine Rotationsachse 102 herum angeordneten Brennern 107 in einen gemeinsamen Brennkammerraum 154 münden, die Flammen 156 erzeugen. Dazu ist die Brennkammer 110 in ihrer Gesamtheit als ringförmige Struktur ausgestaltet, die um die Rotationsachse 102 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen.

Aufgrund der hohen Temperaturen im Inneren der Brennkammer 110 kann zudem für die Hitzeschildelemente 155 bzw. für deren Halteelemente ein Kühlsystem vorgesehen sein. Die Hitzeschildelemente 155 sind dann beispielsweise hohl und weisen ggf. noch in den Brennkammerraum 154 mündende Kühllöcher (nicht dargestellt) auf.

Jedes Hitzeschildelement 155 aus einer Legierung ist arbeitsmediumsseitig mit einer besonders hitzebeständigen Schutzschicht (MCrAlX-Schicht und/oder keramische Beschichtung) ausgestattet oder ist aus hochtemperaturbeständigem Material (massive keramische Steine) gefertigt.

Diese Schutzschichten können ähnlich der Turbinenschaufeln sein, also bedeutet beispielsweise MCrAlX: M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf). Solche Legierungen sind bekannt aus der EP 0 486 489 B1, EP 0 786 017 B1, EP 0 412 397 B1 oder EP 1 306 454 A1, die bzgl. der chemischen Zusammensetzung der Legierung Teil dieser Offenbarung sein sollen.

Auf der MCrAlX kann noch eine beispielsweise keramische Wärmedämmschicht vorhanden sein und besteht und besteht aus dem erfindungsgemäßen Schichtsystem 1.
Durch geeignete Beschichtungsverfahren wie z.B. Elektronenstrahlverdampfen (EB-PVD) werden stängelförmige Körner in der Wärmedämmschicht erzeugt.
Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen.

Wiederaufarbeitung (Refurbishment) bedeutet, dass Turbinenschaufeln 120, 130, Hitzeschildelemente 155 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse in der Turbinenschaufel 120, 130 oder dem Hitzeschildelement 155 repariert. Danach erfolgt eine Wiederbeschichtung der Turbinenschaufeln 120, 130, Hitzeschildelemente 155 und ein erneuter Einsatz der Turbinenschaufeln 120, 130 oder der Hitzeschildelemente 155.

## Patentansprüche

1. Schichtsystem
aufweisend
ein Substrat (4),
auf dem eine äußere keramische Schicht (13) vorhanden ist, die eine Pyrochlorstruktur Gdᵥ(ZrₓHf_{y})O_{z} mit x + y = 2 umfasst.

2. Schichtsystem nach Anspruch 1,
bei dem
die äußere keramische Schicht (13) Gd₂(ZrₓHf_{y})O_{z} umfasst

3. Schichtsystem nach Anspruch 1 oder 2,
bei dem
die äußere keramische Schicht (13) Gdᵥ(ZrₓHf_{y})O₇ umfasst.

4. Schichtsystem nach Anspruch 1, 2 oder 3,
bei dem
die äußere keramische Schicht (13) aus Gdᵥ(ZrₓHf_{y})O_{z} besteht.

5. Schichtsystem nach Anspruch 1, 2, 3 oder 4,
bei dem
die äußere keramische Schicht (13) aus Gdᵥ(ZrₓHf_{y})O_{z} mit x + y = 2 besteht.

6. Schichtsystem nach einem oder mehreren der vorherigen Ansprüche, bei dem
unter der äußeren keramischen Schicht (13) eine innere keramische Schicht (10),
insbesondere eine stabilisierte Zirkonoxidschicht, insbesondere eine Yttrium-stabilisierte Zirkonoxidschicht, vorhanden ist.

7. Schichtsystem nach Anspruch 6,
bei dem
die innere keramische Schicht (10) aus einer 6wt% - 8wt% Yttrium-stabilisierten Zirkonoxidschicht besteht.

8. Schichtsystem nach Anspruch 6 oder 7,
bei dem
die innere keramische Schicht (10) eine Schichtdicke zwischen 10% und 50% der Gesamtschichtdicke (D) von der inneren keramischen Schicht (10) und der äußeren keramischen Schicht (13) aufweist.

9. Schichtsystem nach Anspruch 6, 7 oder 8,
bei dem
die Schichtdicke der inneren keramischen Schicht (10) und der äußeren keramischen Schicht (13) zusammen 300µm beträgt.

10. Schichtsystem nach Anspruch 6, 7 oder 8,
bei dem
die Schichtdicke der inneren Schicht (10) und der äußeren Schicht (13) zusammen 400µm beträgt.

11. Schichtsystem nach Anspruch 1 oder 6,
bei dem
auf dem Substrat (4) und unter der inneren keramischen Schicht (10) oder unter der äußeren keramischen Schicht (13) eine metallische Anbindungsschicht (7), insbesondere aus einer NiCoCrAlX-Legierung,
vorhanden ist.

12. Schichtsystem nach Anspruch 11,
bei dem
die metallische Anbindungsschicht (7) die Zusammensetzung (in wt%)
| | |
|---|---|
| 11% - 13% | Kobalt, insbesondere 12% Kobalt, |
| 20% - 22% | Chrom, insbesondere 21% Chrom, |
| 10,5% - 11,5% | Aluminium, insbesondere 11% Aluminium, |
| 0,3% - 0,5% | Yttrium, insbesondere 0,4% Yttrium, |
| 1,5% - 2,5% | Rhenium und insbesondere 2,0% Rhenium, |
Rest Nickel aufweist.

13. Schichtsystem nach Anspruch 11,
bei dem
die metallische Anbindungsschicht (7) die Zusammensetzung (in wt%)
| | |
|---|---|
| 24% - 26% | Kobalt, insbesondere 25% Kobalt, |
| 16% - 18% | Chrom, insbesondere 17% Chrom, |
| 9,5% - 10,5% | Aluminium, insbesondere 10% Aluminium, |
| 0,3% - 0,5% | Yttrium, insbesondere 0,4% Yttrium, |
| 1% - 2,0% | Rhenium und insbesondere 1,5% Rhenium, |
Rest Nickel aufweist.

14. Schichtsystem nach Anspruch 11, bei dem
die metallische Anbindungsschicht (7) die Zusammensetzung (in wt%)
| | |
|---|---|
| 29% - 31% | Nickel, insbesondere 30% Nickel, |
| 27% - 29% | Chrom, insbesondere 28% Chrom, |
| 7% - 9% | Aluminium, insbesondere 8% Aluminium, |
| 0,5% - 0,7% | Yttrium, insbesondere 0,6% Yttrium, |
| 0,6% - 0,8% | Silizium, insbesondere 0,7% Silizium und |
Rest Kobalt aufweist.

15. Schichtsystem nach Anspruch 11, bei dem
die metallische Anbindungsschicht (7) die Zusammensetzung (in wt%)
| | |
|---|---|
| 27% - 29% | Nickel, insbesondere 28% Nickel, |
| 23% - 25% | Chrom, insbesondere 24% Chrom, |
| 9% - 11% | Aluminium, insbesondere 10% Aluminium, |
| 0,3% - 0,7% | Yttrium, insbesondere 0,6% Yttrium und, |
Rest Kobalt aufweist.

16. Schichtsystem nach Anspruch 1, 2, 3, 4 oder 5, bei dem
das Mischungsverhältnis von Hafnium und Zirkon 10:90 beträgt.

17. Schichtsystem nach Anspruch 1, 2, 3, 4 oder 5, bei dem
das Mischungsverhältnis von Hafnium und Zirkon 20:80 beträgt.

18. Schichtsystem nach Anspruch 1, 2, 3, 4 oder 5, bei dem
das Mischungsverhältnis von Hafnium und Zirkon 30:70 beträgt.

19. Schichtsystem nach Anspruch 1, 2, 3, 4 oder 5, bei dem
das Mischungsverhältnis von Hafnium und Zirkon 40:60 beträgt.

20. Schichtsystem nach Anspruch 1, 2, 3, 4 oder 5, bei dem
das Mischungsverhältnis von Hafnium und Zirkon 50:50 beträgt.

21. Schichtsystem nach Anspruch 1, 2, 3, 4 oder 5, bei dem
das Mischungsverhältnis von Hafnium und Zirkon 60:40 beträgt.

22. Schichtsystem nach Anspruch 1, 2, 3, 4 oder 5, bei dem
das Mischungsverhältnis von Hafnium und Zirkon 70:30 beträgt.

23. Schichtsystem nach Anspruch 1, 2, 3, 4 oder 5, bei dem
das Mischungsverhältnis von Hafnium und Zirkon 80:20 beträgt.

24. Schichtsystem nach Anspruch 1, 2, 3, 4 oder 5, bei dem
das Mischungsverhältnis von Hafnium und Zirkon 90:10 beträgt.

25. Schichtsystem nach Anspruch 1, 2, 3, 4 oder 5, bei dem
y > x ist.

26. Schichtsystem nach Anspruch 1, 2, 3, 4 oder 5, bei dem
y < x ist.

## Claims

1. Layer system
having
a substrate (4),
on which there is an outer ceramic layer (13) which comprises a pyrochlore structure Gdᵥ(ZrₓHf_{y})O_{z} where x + y = 2.

2. Layer system according to Claim 1,
in which
the outer ceramic layer (13) comprises Gd₂(ZrₓHf_{y})O_{z}.

3. Layer system according to Claim 1 or 2,
in which
the outer ceramic layer (13) comprises Gdᵥ(ZrₓHf_{y})O₇.

4. Layer system according to Claim 1, 2 or 3,
in which
the outer ceramic layer (13) consists of Gdᵥ(ZrₓHf_{y})O_{z}.

5. Layer system according to Claim 1, 2, 3 or 4,
in which
the outer ceramic layer (13) consists of Gdᵥ(ZrₓHf_{y})O_{z} where x + y = 2.

6. Layer system according to one or more of the preceding claims, in which
an inner ceramic layer (10),
in particular a stabilized zirconium oxide layer,
in particular an yttrium-stabilized zirconium oxide layer, is present beneath the outer ceramic layer (13).

7. Layer system according to Claim 6,
in which
the inner ceramic layer (10) consists of a 6 wt% - 8 wt% yttrium-stabilized zirconium oxide layer.

8. Layer system according to Claim 6 or 7,
in which
the inner ceramic layer (10) has a layer thickness of between 10% and 50% of the total layer thickness (D) of the inner ceramic layer (10) and the outer ceramic layer (13).

9. Layer system according to Claim 6, 7 or 8,
in which
the layer thickness of the inner ceramic layer (10) and the outer ceramic layer (13) together amounts to 300 µm.

10. Layer system according to Claim 6, 7 or 8,
in which
the layer thickness of the inner layer (10) and the outer layer (13) together amounts to 400 µm.

11. Layer system according to Claim 1 or 6,
in which
a metallic bonding layer (7),
in particular of a NiCoCrAlX alloy,
is present on the substrate (4) and beneath the inner ceramic layer (10) or beneath the outer ceramic layer (13).

12. Layer system according to Claim 11,
in which
the metallic bonding layer (7) has the composition (in wt%)
| | |
|---|---|
| 11% - 13% | cobalt, in particular 12% cobalt, |
| 20% - 22% | chromium, in particular 21% chromium, |
| 10.5% - 11.5% | aluminum, in particular 11% aluminum, |
| 0.3% - 0.5% | yttrium, in particular 0.4% yttrium, |
| 1.5% - 2.5% | rhenium and in particular 2.0% rhenium, |
remainder nickel.

13. Layer system according to Claim 11,
in which
the metallic bonding layer (7) has the composition (in wt%)
| | |
|---|---|
| 24% - 26% | cobalt, in particular 25% cobalt, |
| 16% - 18% | chromium, in particular 17% chromium, |
| 9.5% - 10.5% | aluminum, in particular 10% aluminum, |
| 0.3% - 0.5% | yttrium, in particular 0.4% yttrium, |
| 1% - 2.0% | rhenium and in particular 1.5% rhenium, |
remainder nickel.

14. Layer system according to Claim 11,
in which
the metallic bonding layer (7) has the composition (in wt%)
| | |
|---|---|
| 29% - 31% | nickel, in particular 30% nickel, |
| 27% - 29% | chromium, in particular 28% chromium, |
| 7% - 9% | aluminum, in particular 8% aluminum, |
| 0.5% - 0.7% | yttrium, in particular 0.6% yttrium, |
| 0.6% - 0.8% | silicon, in particular 0.7% silicon and |
remainder cobalt.

15. Layer system according to Claim 11,
in which
the metallic bonding layer (7) has the composition (in wt%)
| | |
|---|---|
| 27% - 29% | nickel, in particular 28% nickel, |
| 23% - 25% | chromium, in particular 24% chromium, |
| 9% - 11% | aluminum, in particular 10% aluminum, |
| 0.3% - 0.7% | yttrium, in particular 0.6% yttrium and, |
remainder cobalt.

16. Layer system according to Claim 1, 2, 3, 4 or 5,
in which
the mixing ratio of hafnium and zirconium is 10:90.

17. Layer system according to Claim 1, 2, 3, 4 or 5,
in which
the mixing ratio of hafnium and zirconium is 20:80.

18. Layer system according to Claim 1, 2, 3, 4 or 5,
in which
the mixing ratio of hafnium and zirconium is 30:70.

19. Layer system according to Claim 1, 2, 3, 4 or 5,
in which
the mixing ratio of hafnium and zirconium is 40:60.

20. Layer system according to Claim 1, 2, 3, 4 or 5,
in which
the mixing ratio of hafnium and zirconium is 50:50.

21. Layer system according to Claim 1, 2, 3, 4 or 5,
in which
the mixing ratio of hafnium and zirconium is 60:40.

22. Layer system according to Claim 1, 2, 3, 4 or 5,
in which
the mixing ratio of hafnium and zirconium is 70:30.

23. Layer system according to Claim 1, 2, 3, 4 or 5,
in which
the mixing ratio of hafnium and zirconium is 80:20.

24. Layer system according to Claim 1, 2, 3, 4 or 5,
in which
the mixing ratio of hafnium and zirconium is 90:10.

25. Layer system according to Claim 1, 2, 3, 4 or 5,
in which
y > x.

26. Layer system according to Claim 1, 2, 3, 4 or 5,
in which
y < x.

## Revendications

1. Système stratifié
comprenant
un substrat (4),
sur lequel il y a une couche (13) extérieure en céramique, qui comprend une structure pyrochlore Gdᵥ(ZrₓHf_{y})O_{z} avec x + y = 2.

2. Système stratifié suivant la revendication 1,
dans lequel
la couche (13) extérieure en céramique comprend du Gd₂(ZrₓHf_{y})O_{z}.

3. Système stratifié suivant la revendication 1 ou 2,
dans lequel
la couche (13) extérieure en céramique comprend du Gdᵥ(ZrₓHf_{y})O₇.

4. Système stratifié suivant la revendication 1, 2 ou 3,
dans lequel
la couche (13) extérieure en céramique consiste du Gdᵥ(ZrₓHf_{y})O_{z}.

5. Système stratifié suivant la revendication 1, 2, 3 ou 4, dans lequel
la couche (13) extérieure en céramique consiste du Gdᵥ(ZrₓHf_{y})O_{z} avec x + y = 2.

6. Système stratifié suivant l'une ou plusieurs des revendications précédentes,
dans lequel
il y a, sous la couche (13) extérieure en céramique, une couche (10) intérieure en céramique,
notamment une couche d'oxyde de zirconium stabilisé, notamment une couche d'oxyde zirconium stabilisé par de l'yttrium.

7. Système stratifié suivant la revendication 6,
dans lequel
la couche (10) intérieure en céramique consiste en une couche d'oxyde de zirconium stabilisé par de 6% en poids à 8% en poids d'yttrium.

8. Système stratifié suivant la revendication 6 ou 7,
dans lequel
la couche (10) intérieure en céramique a une épaisseur comprise entre 10% et 50% de l'épaisseur (D) totale de la couche (10) intérieure en céramique et de la couche (13) extérieure en céramique.

9. Système stratifié suivant la revendication 6, 7 ou 8, dans lequel
l'épaisseur de la couche (10) intérieure en céramique et de la couche (13) extérieure en céramique représentent ensemble 300 µm.

10. Système stratifié suivant la revendication 6, 7 ou 8, dans lequel
l'épaisseur de la couche (10) intérieure et de la couche (13) extérieure représentent ensemble 400 µm.

11. Système stratifié suivant la revendication 1 ou 6, dans lequel
il y a, sur le substrat (4) et en dessous de la couche (10) intérieure en céramique ou en dessous de la couche (13) extérieure en céramique, une couche (7) métallique d'accrochage,
notamment en un alliage de NiCoCrAlX.

12. Système stratifié suivant la revendication 11,
dans lequel
la couche (7) métallique d'accrochage a la composition (en % en poids)
| | |
|---|---|
| de 11% à 13% | de cobalt, notamment 12% de cobalt, |
| de 20% à 22% | de chrome, notamment 21% de chrome, |
| de 10,5% à 11,5% | d'aluminium, notamment 11% d'aluminium, |
| de 0,3% à 0,5% | d'yttrium, notamment 0,4% d'yttrium, |
| de 1,5% à 2,5% | de rhénium, notamment 2,0% de rhénium, |
le reste étant du nickel.

13. Système stratifié suivant la revendication 11,
dans lequel
la couche (7) métallique d'accrochage a la composition (en % en poids)
| | |
|---|---|
| de 24% à 26% | de cobalt, notamment 25% de cobalt, |
| de 16% à 18% | de chrome, notamment 17% de chrome, |
| de 9,5% à 10,5% | d'aluminium, notamment 10% d'aluminium, |
| de 0,3% à 0,5% | d'yttrium, notamment 0,4% d'yttrium, |
| de 1% à 2% | de rhénium, notamment 1,5% de rhénium, |
le reste étant du nickel.

14. Système stratifié suivant la revendication 11,
dans lequel
la couche (7) métallique d'accrochage a la composition (en % en poids)
| | |
|---|---|
| de 29% à 31% | de nickel, notamment 30% de nickel, |
| de 27% à 29% | de chrome, notamment 28% de chrome, |
| de 7% à 9% | d'aluminium, notamment 8% d'aluminium, |
| de 0,5% à 0,7% | d'yttrium, notamment 0,6% d'yttrium, |
| de 0,6% à 0,8% | de silicium, notamment 0,7% de silicium et |
le reste étant du cobalt.

15. Système stratifié suivant la revendication 11,
dans lequel
la couche (7) métallique d'accrochage a la composition (en % en poids)
| | |
|---|---|
| de 27% à 29% | de nickel, notamment 28% de nickel, |
| de 23% à 25% | de chrome, notamment 24% de chrome, |
| de 9% à 11% | d'aluminium, notamment 10% d'aluminium, |
| de 0,3% à 0,7% | d'yttrium, notamment 0,6% d'yttrium et |
le reste étant du nickel.

16. Système stratifié suivant la revendication 1, 2, 3, 4 ou 5, dans lequel
le rapport de mélange de l'hafnium et du zirconium est de 10:90.

17. Système stratifié suivant la revendication 1, 2, 3, 4 ou 5, dans lequel
le rapport de mélange de l'hafnium et du zirconium est de 20:80.

18. Système stratifié suivant la revendication 1, 2, 3, 4 ou 5, dans lequel
le rapport de mélange de l'hafnium et du zirconium est de 30:70.

19. Système stratifié suivant la revendication 1, 2, 3, 4 ou 5, dans lequel
le rapport de mélange de l'hafnium et du zirconium est de 40:60.

20. Système stratifié suivant la revendication 1, 2, 3, 4 ou 5, dans lequel
le rapport de mélange de l'hafnium et du zirconium est de 50:50.

21. Système stratifié suivant la revendication 1, 2, 3, 4 ou 5, dans lequel
le rapport de mélange de l'hafnium et du zirconium est de 60:40.

22. Système stratifié suivant la revendication 1, 2, 3, 4 ou 5, dans lequel
le rapport de mélange de l'hafnium et du zirconium est de 70:30.

23. Système stratifié suivant la revendication 1, 2, 3, 4 ou 5, dans lequel
le rapport de mélange de l'hafnium et du zirconium est de 80:20.

24. Système stratifié suivant la revendication 1, 2, 3, 4 ou 5, dans lequel
le rapport de mélange de l'hafnium et du zirconium est de 90:10.

25. Système stratifié suivant la revendication 1, 2, 3, 4 ou 5, dans lequel
y > x.

26. Système stratifié suivant la revendication 1, 2, 3, 4 ou 5, dans lequel
y < x.
